# EUROPEAN PATENT APPLICATION

(11) **EP 1 118 411 A1**
(43) Date of publication of application: **25.07.2001**
(21) Application number: 00127249.1
(22) Date of filing: 15.12.2000
(51) Int. Cl.: B23K 1/005

(54) **Method and device for soldering components**

(30) Priority: 17.12.1999 FR 9916304
(71) Applicant: F.C.I. - Framatome Connectors International, 92400 Courbevoie (FR)
(72) Inventor: Schmit, Christian, 92380 Garches (FR)
(74) Representative: Beetz & Partner Patentanwälte

(57) **Abstract**

Device and soldering process for soldering components on flexible circuits, the device consisting of a device (8) for infrared preheating and an application device (12) for heat spots calibrated by duration, power and diameter, the method consisting of combining an application stage of the calibrated heat spots and a preheating stage.

## Description

This invention relates to an improved soldering method and to a device for electronic components on a flexible circuit and, more particularly, a method and device appropriate to flexible circuits which have a weak resistance to high temperatures.

The carry over and soldering methods for components on rigid circuits are well known and, for surface mounted components, the techniques are, for example, infrared techniques or re-melting soldering paste techniques. All these techniques expose the substrate to relatively high temperatures in order to activate the soldered paste used and are not adapted to the flexible circuits usually made in polyester material.

The EP 0 804 990 A1 document teaches a carry over and soldering surface mounted component technique adapted to flexible substrates possessing a weak resistance to high temperatures.

This method includes the following stages :
- Placing a flexible substrate provided with surface strip conductors on a support,
- Placing a switch cover provided with openings on the support in such a way that the substrate is trapped between the switch cover and the support to form a handling connection. The openings leave exposed the areas which should contain the carry over components,
- Application of a soldering paste on the areas of the strip conductors which are supposed to receive the pastes or the soldering component terminations whether before placing the switch cover or after,
- Placing soldering components in a soldering position on the substrate,
- Application of a first heating of the connection to preheat the soldering paste to a first temperature,
- Higher heating of connection zones to re-melt the soldering paste and,
- Cooling the connection so that the paste is solidified and adheres firmly to the terminations and the strip conductors.

In this document the method for raising the soldering paste to the first temperature is a radiating method, the support and the switch cover being provided with reflecting surfaces separated from the substrate in order to prevent raising the temperature of the substrate. This radiating method is based on a heating device with a gas float burner.

The support and switch cover can be built in a material which conducts and resists heat to dissipate the heat separated from the substrate. Because of the support and switch cover system the preheat heat is limited to 90 ° C at the level of the substrate while the heat obtained normally would be around 250 to 370 ° C.

The method described to obtain the second heating temperature, still in relation to document EP 0 804 990, consists of directing a hot gas jet on a limited zone of the connection or else a jet of a size at least equal to that of the connection but of a weak thickness in a direction perpendicular to this width.

The connection is crossed by the jet in a period of time just enough to raise the temperature of the paste to its complete activation.

This technique is well adapted to flexible circuits which have a melting temperature less than or equal to the second temperature typical of polyesters which have a contraction of less than 0,1 % for a temperature of 160 °C. Nevertheless a better location and a greater precision in controlling the second temperature or fusion temperature of the paste is desirable to obtain a greater regularity of the solders.

Moreover, the use of a gas stream can cause a misalignment of the soldering components.

In addition this technique causes a great loss of heat to obtain the first temperature and depends on the speed of movement of the support under the radiating devices.

The present invention proposes to perfect the process describes here above to obtain a better control of the first temperature and to increase the precision of the second heat.

To this end the present invention relates to a component soldering method on flexible circuits including particularly the following stages :
- Connection of the flexible circuit on a support and positioning on the support a switch cover provided with openings opposite the carry over position of components which are supposed to be connected to flexible circuit strips,
- Application of soldering paste on the parts of the strip conductors which are supposed to receive the paste or the soldering components terminations whether before placing the switch cover or after,
- Placing the components on the flexible circuit strips,
- Heating at least one zone of the ensemble by radiating the soldering paste to a first temperature of preheating,
- Sequential application of heat spots calibrated by duration, power and diameter on the termination zones of the soldering paste,

Preferably the calibrated heat spots are produced by an infrared laser,

This invention concerns also a soldering component device on a substrate such as a flexible circuit by soldering consisting of an infrared preheating device and a device for applying heat spots calibrated by duration, power and diameter.

The device for applying spots can be an infrared laser. This infrared laser can be laid out on a transport frame on two perpendicular axes between them and parallel to the support plane. The support of the flexible circuit can be in this case fixed during the sequential application stage of the spots.

In alternative embodiment modes of the device, the laser is fixed and a controlled system of focus and direction of the spot is arranged opposite the laser.

During the sequential application stage of the spots, the support can be fixed and the controlled system capable of directing the laser beam on two perpendicular axes. Alternatively, the support can be mobile and move in a longitudinal direction, the controlled system being able then to direct the beam in an axis perpendicular to the direction of support movement.

In a preferential embodiment mode of the device according to the invention the radiating heating device is made up of one or more infrared lamps.

Preferably, the spot calibrating device includes mechanisms regulating the duration of the spot and one of the regulating mechanisms of focusing and positioning the spot adapted to raise the temperature either on each termination or on a number of component terminations.

The reader will better understand the nature of the invention from a description of a non-limiting embodiment mode of the invention which will follow in reference to the Fig. which represent :
- In Fig. 1 a view in perspective of the support, flexible circuit and switch cover ensemble,
- In Fig. 2 a soldering device according to the invention,
- In Fig. 3 a diagram of a control device of the device according to the invention,
- In Fig. 4 the diagrammatic representation of a focusing system for the device according to the invention.

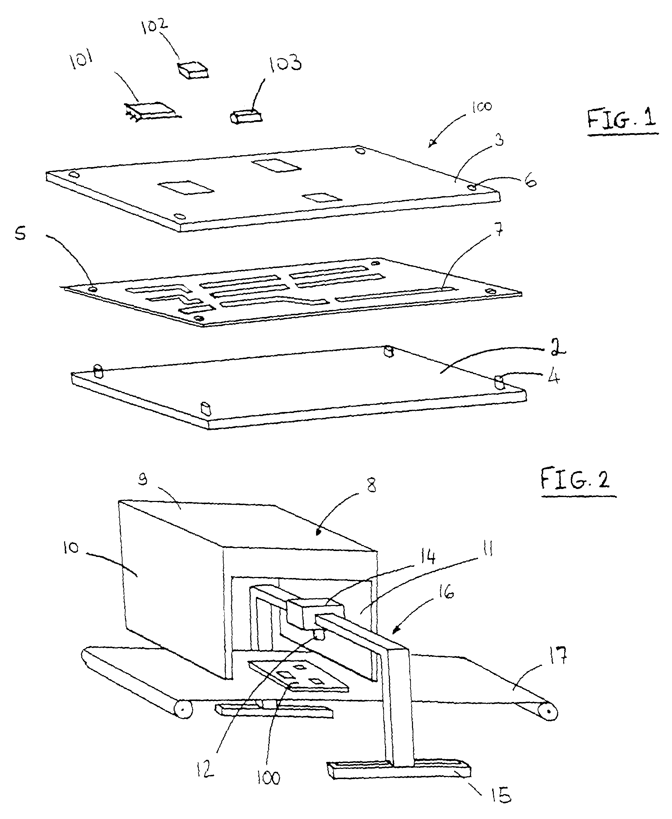

According to the placing and soldering component method (101, 102, 103) on flexible circuits, the first stage is as can be seen in Fig. 1 the connection of the flexible circuit (1) on a support (2) and the positioning on the support of a switch cover (3) provided with openings opposite the carry over position of the components which are meant to be connected to flexible circuit strips. This, in a similar way to the prior art known, rigidifies the flexible circuit to allow the positioning of components and construct a shield on the zones which are not meant to be subjected to heat.

Methods of positioning of each of these elements such as pawns(4) and positioning holes (5, 6) can be provided for.

The application of soldering paste on the parts of the strip conductors (7) which are meant to receive the paste or the soldering component terminations can be done before placing the switch cover.

In the event of many components having to be soldered or components of small dimensions, application of the soldering paste can take place before positioning the switch cover notably in the event of a traditional application procedure by shield or grid for which the extra thickness of the switch cover would limit the precision of the application of the paste.

Where few components are provided for, application of the paste can also be carried out after positioning the switch cover. Similarly, placing components on the flexible circuit strips is possible before placing the switch cover (3), the switch cover here also can be an inconvenience for the placing tools.

On the other hand positioning the components by a placing arm coupled with a shape recognition device after putting in place the switch cover is possibly facilitated by the contrast of the switch cover with the flexible circuit.

As can be seen in Fig. 2 the preheating device of at least one ensemble zone (100) made up of support (2), circuit (1) and the switch cover (3) by radiating to a first preheating temperature of the soldering paste includes one or more infrared lamps (8) arranged in a frame (9). This frame can be arranged in a semi-formed enclosure of which two walls (10, 11) are shown in Fig. 2.

The sequential application of heat spots calibrated by duration, power and diameter on the soldering component termination zones is carried out by an infrared laser device (12) which can be an infrared diode laser, possibly pulsated.

In a first embodiment mode the infrared laser is arranged on a trolley (14) and is mobile on two perpendicular axes and parallel to the general location plan (100), the trolley (14) can in this case be immobilised during the sequential application stage of the spots. The trolley (14) can be mobile on a rail supported by a support bridge (13), the bridge being itself laid out on the guide rails (15).

The bridge (13) moves longitudinally in relation to a transport device (17) of the ensemble (100) while the trolley moves laterally in relation to this transport device.

In an alternative embodiment mode of the device the laser (12) is fixed and laid out at a longitudinal distance from the entrance in the preheating system (8) fixed to attain a preheating temperature of around 90°.

A controlled system of focus (18) and direction (20) of the spot is laid out opposite the laser. The controlled system is capable of directing the laser beam by two perpendicular axes (x, y) or else the support can be mobile according to a particular direction and then the controlled system can be capable of directing the beam by an axis (y) perpendicular to the movement of direction of the support.

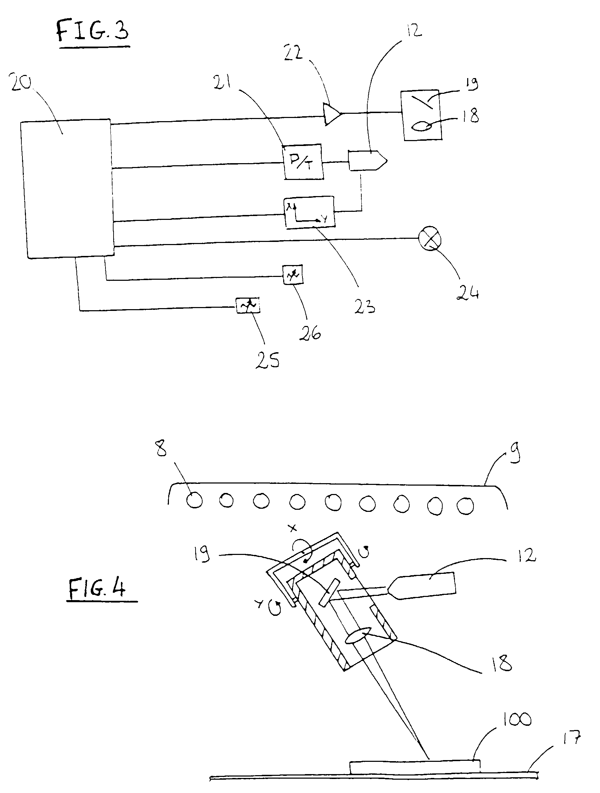

Fig. 3 shows a control device of the soldering process. This device is mainly made up of a calculator (20) guiding the calibration of the spots by duration by a power unit (21) feeding the laser (12) and guiding the focus and positioning of the spots by a control unit (22) of the mechanisms regulating focus and position (18, 19).

The duration of each spot is fixed in such a way as to be capable of raising the temperature either by each termination or by a number of terminations depending on the dimension of the soldering component.

The calculator also includes a component lead for controlling (23) motors guiding the positioning of the trolley (14) and the bridge (13) as well as a control unit (24) of the infrared lamps (8).

The calculator determines the duration of the lighting of the lamps and the spots as a function of pre-established measures and of the dimensions and thermal strip constants and soldering components and can include temperature collectors (25), (26) to regulate the heat.

This device particularly allows, compared to the method know in the prior art, a reduction of the switch cover mass.

## Claims

1. Soldering device for soldering components (101,102,103) on a flexible circuit consisting of a device (8) for infrared preheating and a device (12, 18, 19) for applying heat spots calibrated by duration, power and diameter, characterised by the fact that the application device of the calibrated heat spots includes an infrared laser(12).

2. Device according to one of claims 1, characterised by the fact that the infrared laser is laid out on a transport frame (16) according to two perpendicular axes and parallel to the support plane.

3. Device according to one of claims 1 or 2. characterised by the fact that a controlled system (18, 19) of focus and direction of the spot is laid out opposite the laser.

4. Device according to one of the preceding claims, characterised by the fact that the radiation preheating device is made up of one or more infrared lamps (8).

5. A device according to one of the preceding claims, characterised by the fact that the spot calibration system includes mechanisms regulating the duration (21) of the spot and mechanisms regulating focus (18, 19) adapted to raise the temperature either on each termination or on a number of component terminations.

6. Soldering component method on flexible circuits, characterised by the fact that it includes particularly the following stages:
- Connection of flexible circuit on a support (2) and positioning on a support of a switch cover (3) provided with openings opposite the carry over position of the components (101, 102, 103) which are meant to be connected to flexible circuit strips ;
- Application of soldering paste on the parts of the strip conductors (7) which are supposed to receive the paste or the soldering component termination whether before placing the cover or after ;
- Placing the components on the flexible circuit strips ;
- Heating at least one zone of the ensemble by radiating the soldering paste to a first temperature of preheating
- Sequential application of heat spots calibrated by duration, power and diameter on the termination zones of the soldering paste, the application device of the calibrating heat spots including an infrared laser (12).

7. Method according to claim 6, characterised by the fact that the support (2) is fixed during the sequential application stage of the spots.

8. Method according to claim 7, characterised by the fact that a controlling system directs the laser beam generating the spots in two perpendicular axes during the sequential application stage of the spots.

9. Method according to claim 6, characterised by the fact that the support moves in a longitudinal direction during the sequential application stage of the spots and that a controlled system directs a laser beam generating the spots in a direction perpendicular to the direction of the support movement..
